# EUROPÄISCHE PATENTSCHRIFT

(11) **EP 4 208 064 B1**
(45) Veröffentlichungstag und Bekanntmachung des Hinweises auf die Patenterteilung: **21.08.2024**
(21) Anmeldenummer: 21769330.8
(22) Anmeldetag: 25.08.2021
(51) Int. Cl.: A45F 3/24

(54) **ZUSAMMENLEGBARES TRAGGESTELL FÜR EINE HÄNGEMATTE**
COLLAPSIBLE SUPPORT FRAME FOR A HAMMOCK
STRUCTURE SUPPORT PLIANTE POUR UN HAMAC

(30) Priorität: 02.09.2020 AT 5017120 U
(43) Veröffentlichungstag der Anmeldung: 12.07.2023
(73) Patentinhaber: Kitzberger, Max, 4120 Neufelden (AT)
(72) Erfinder: Kitzberger, Max, 4120 Neufelden (AT)
(74) Vertreter: Hübscher & Partner Patentanwälte GmbH
(86) Internationale Anmeldenummer: PCT/AT2021/060296
(87) Internationale Veröffentlichungsnummer: WO 2022/047512

(56) Entgegenhaltungen:
- CN-A- 103 120 469
- DE-U1- 202008 007 999
- US-A- 182 049

## Beschreibung

### Technisches Gebiet

Die Erfindung bezieht sich auf ein zusammenlegbares Traggestell für eine Hängematte mit einem Gestellkörper aus einem Längsträger und je drei an den beiden Enden des Längsträgers vorgesehenen Streben, von denen zwei als Fußstreben und die dritte Strebe als Tragarm mit einem Anschlagpunkt für die Hängematte dienen, wobei jeweils die drei Streben an den beiden Enden des Längsträgers als auch die Fußstreben an den einander gegenüberliegenden Enden des Längsträgers miteinander durch an den Strebenenden angreifende Zugmittel verbunden sind.

### Stand der Technik

Um ein einfaches, zusammenlegbares Traggestell für eine Hängematte zu erhalten, ist es bekannt (DE 20110262 U1), zwei Tragarme für die Hängematte mit zwei an den Tragarmen anschlagbegrenzt angelenkten Fußstreben vorzusehen, die mit dem zugehörigen Tragarm in einer Ebene liegen und durch Spannseile verspannt werden, die die Enden der beiden Fußstreben miteinander und mit dem Ende des Tragarms verbinden. Werden diese an den kopf- und fußseitigen Enden der Hängematte am Boden abgestützten Gestellteile mit einem bodenseitig verankerten Spannseil abgespannt, so wird die Stabilität der beiden um die Fußabstützung schwenkbaren Gestellteile lediglich durch die Belastung der Hängematte erreicht. Um ein stabiles Gestell zu erreichen, können die beiden kopf- und fußseitigen Tragarme miteinander durch eine Längsstrebe im Bereich der Gelenke zwischen Tragarm und Fußstreben verbunden werden, um die Tragarme an den über die Gestellteile hinaus verlängerten Enden der Längsstrebe abspannen zu können. Wird eine gelenkige Verbindung zwischen der Längsstrebe und den Tragarmen vorgesehen, so wird hinsichtlich der Stabilität des Gestells nichts gewonnen. Bei einer starren Verbindung wird diese Verbindung allerdings wiederum mit den auftretenden Biegemomenten belastet, weil durch die gewählten Seilabspannungen lediglich für die kopf- und fußseitigen Gestellteile ein stabiler Dreiecksverband sichergestellt werden kann.

Um diese Nachteile zu vermeiden und die auftretenden Gewichts- und Drehmomentbelastungen sicher aufnehmen zu können, wurde bereits bei einem zusammenlegbares Traggestell für eine Hängematte mit einem zu einer Längsmittelebene symmetrischen Gestellkörper aus geraden Streben und die Streben miteinander verbindenden Knotenstücken, die Steckaufnahmen für die Streben bilden, vorgeschlagen (AT 518 829 B1), dass der Gestellkörper zwei Knotenstücke mit Steckaufnahmen für je drei ein Tetraeder aufspannende Streben umfasst, von denen zwei als Fußstreben und die dritte in der Symmetrieebene zwischen den beiden Fußstreben verlaufende Strebe als Tragarm für die Hängematte ausgebildet sind, dass zwischen den beiden Knotenstücken auf der dem Tetraeder abgewandten Seite eine in fluchtende Steckaufnahmen der Knotenstücke eingreifende Längsstrebe vorgesehen ist und dass sowohl die jeweils einen Tetraeder bildenden Streben als auch die Fußstreben der einander gegenüberliegenden Knotenstücke miteinander durch an den Strebenenden angreifende Zugmittel verbunden sind. Durch die zusätzliche gegenseitige Zugmittelabspannung der von einem Knotenstück ausgehenden, einen Tetraeder aufspannenden Streben untereinander sowie der Fußstreben der einander gegenüberliegenden Tetraeder werden die Streben im Wesentlichen als Druckstäbe beansprucht, sodass die Knotenstücke weitgehend frei von Belastungen durch Biegemomente bleiben. Bei einem Zerlegen des Traggestells liegen allerdings die Einzelelemente des Gestellkörpers als lose Einzelteile vor, was die Handhabung aufwendig macht. Außerdem bleibt hinsichtlich der Lastabtragung das jeweilige Gewicht eines Benützers der Hängematte unberücksichtigt.

Das Dokument CN 103 120 469 A offenbart ein zusammenlegbares Traggestell für eine Hängematte gemäß dem Oberbegriff des Anspruchs 1.

### Darstellung der Erfindung

Der Erfindung liegt somit die Aufgabe zugrunde, ein zerlegbares Traggestell für eine Hängematte so auszugestalten, dass eine einfache Handhabung beim Aufbau und beim Zusammenlegen des Traggestells und darüber hinaus eine vom Gewicht eines Benützers der Hängematte abhängige Aussteifung des Gestellkörpers sichergestellt werden können.

Ausgehend von einem zusammenlegbaren Traggestell der eingangs geschilderten Art löst die Erfindung die gestellte Aufgabe dadurch, dass der Anschlagpunkt für die Hängematte an den beiden Tragarmen an einem Arm eines doppelarmigen Schwenkhebels vorgesehen ist, an dessen anderem Arm die Zugmittel zu den beiden Fußstreben angreifen.

Das Vorsehen eines Längsträgers, an dessen Enden die Fußstreben und Tragarme angelenkt sind, bietet die Voraussetzung für eine einfache Handhabung des Traggestells zum Auf- und Abbau, weil ja hierfür lediglich die Streben in die abgespreizte Arbeitsstellung ausgeschwenkt bzw. in die Ruhestellung gegen den Längsträger eingeklappt werden müssen. Aufgrund der Anlenkung der Streben am Längsträger einerseits und deren Abspannung über Zugmittel anderseits bleiben die Streben im Wesentlichen frei von Biegebelastungen, sodass die auftretenden Belastungen durch eine Hängemattenbenützung über die an den Strebenenden angreifenden Zugmittel abgetragen werden, und zwar in Form von Druckbelastungen der Streben. Da die Tragarme mit doppelarmigen Schwenkhebeln verbunden sind, die an einem Hebelarm einen Anschlagpunkt für die Hängematte bilden, während am anderen Hebelarm die Zugmittel zu den jeweiligen Fußstreben angreifen, wird in konstruktiv einfacher Art ein das jeweilige Gewicht eines Hängemattenbenützers berücksichtigender Lastausgleich erreicht. Die Hebelarmlängen bzw. -winkel erlauben dabei die Einhaltung entsprechender Übersetzungsverhältnisse, die bei Bedarf durch eine Verlagerung beispielsweise des Anschlagpunktes für die Hängematte geändert werden können.

Um für das zusammengelegte Traggestell eine gedrängte Bauweise vorsehen zu können, kann der Längsträger Aufnahmenuten für die in die Ruhestellung eingeklappten Streben aufweisen, die vorzugsweise in den Aufnahmenuten verrastet sind. Im Allgemeinen ist der Längsträger kürzer als die doppelte Länge eines Tragarms. Aus diesem Grund empfiehlt es sich, die Tragarme gegeneinander versetzt am Längsträger anzulenken, um sie nebeneinander entlang des Längsträgers unterbringen zu können. Diese gegenseitige Versetzung der Tragarme spielt für die Aufhängung der Hängematte keine Rolle, sichert jedoch eine kompakte Baugröße für die Transportstellung des Traggestells, weil die Mindestlänge des zusammengeklappten Gestellkörpers lediglich der Länge der Tragarme bzw. der doppelten Länge der Fußstreben entsprechen muss, wenn die Länge der Tragarme kleiner als die doppelte Länge der Fußstreben ist, was jedoch üblicherweise nicht der Fall sein wird.

Damit für die die Streben an einem Ende des Längsträgers verbindenden Zugmittel eine gelichmäßige Belastung sichergestellt werden kann, können diese Zugmittel zwischen den Tragarmen und den zugehörigen Fußstreben eine verschiebbar in den Schwenkhebeln der Tragarme einhängbare Schlaufe bilden.

Ist der Längsträger des Gestellkörpers als Kastenträger ausgebildet, so ergeben sich vorteilhafte Belastungsbedingungen mit der zusätzlichen Möglichkeit, den Hohlraum des Kastenträgers als Stauraum insbesondere für die Hängematte und die Zugmittel nützen zu können.

### Kurze Beschreibung der Erfindung

In der Zeichnung ist der Erfindungsgegenstand beispielsweise dargestellt. Es zeigen
- Fig. 1: ein erfindungsgemäßes Traggestell für eine Hängematte in einer vereinfachten Seitenansicht,
- Fig. 2: dieses Traggestell in einer zum Teil aufgerissenen Stirnansicht in einem größeren Maßstab,
- Fig. 3: das Ende eines Tragarms mit einem Schwenkarm zum Anschlagen der Hängematte in einer Seitenansicht in einem größeren Maßstab und
- Fig.4: das Traggestell in einer zusammengelegten Ruhestellung in einer Seitenansicht in einem größeren Maßstab.

### Wege zur Ausführung der Erfindung

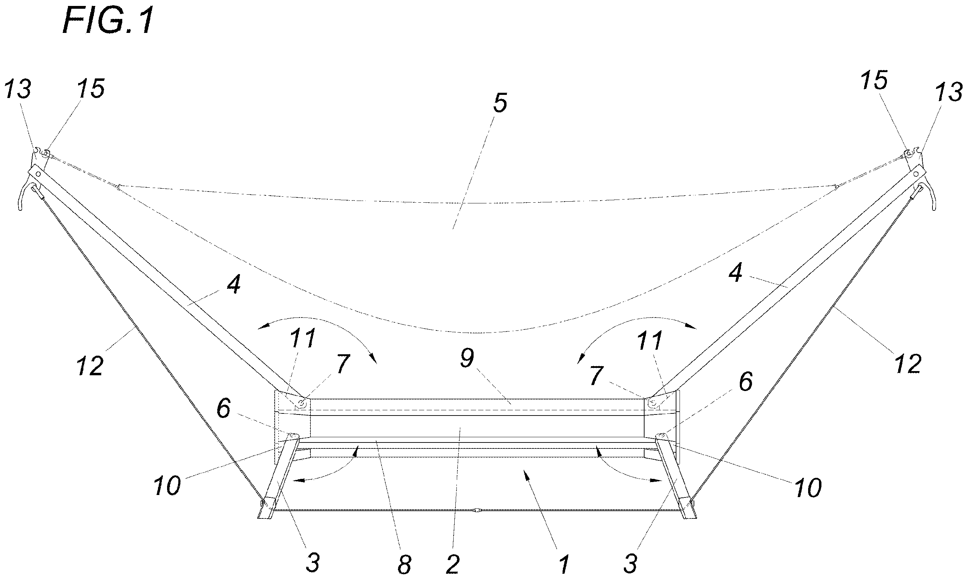

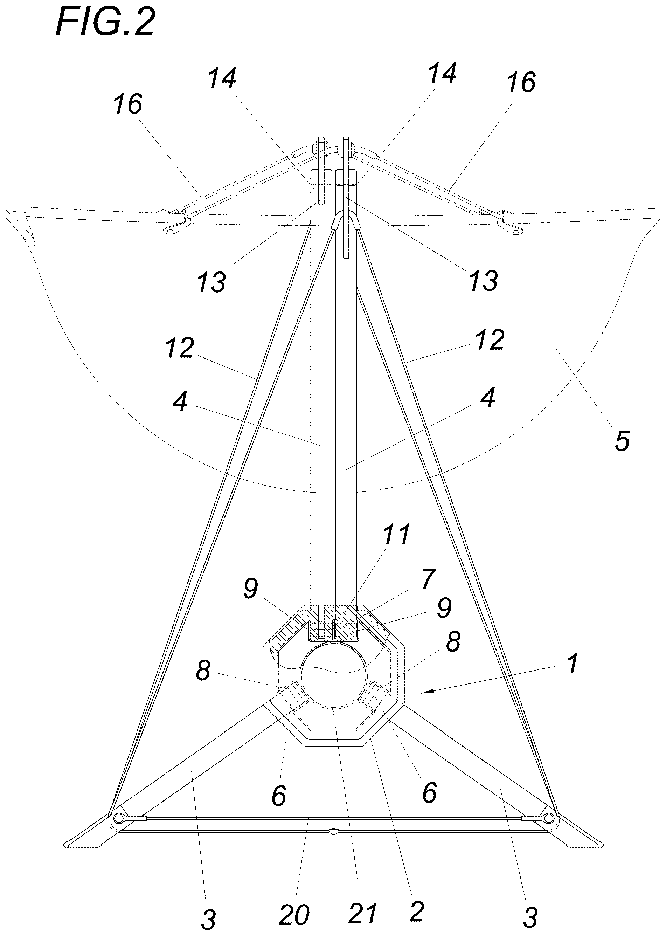

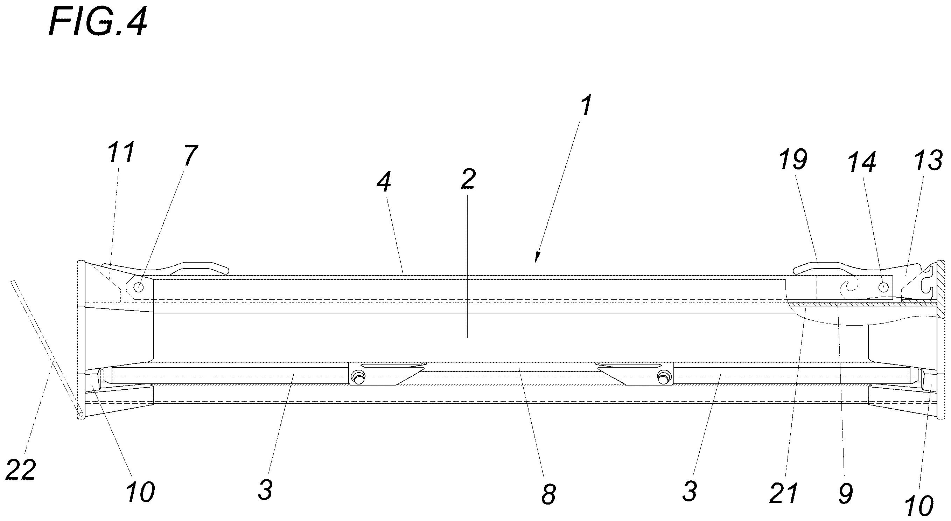

Das Traggestell weist einen Gestellkörper 1 auf, der einen Längsträger 2 in Form eines hohlen Kastenträgers und je drei an den beiden Enden dieses Kastenträgers angelenkte Streben umfasst, nämlich je zwei Fußstreben 3 und eine Strebe als Tragarm 4 für eine Hängematte 5. Diese Streben sind aus einer gegen den Längsträger 2 eingeklappten, in Fig. 4 gezeichneten Ruhestellung um Anlenkachsen 6, 7 in eine vom Längsträger 2 abgespreizte Arbeitsstellung gemäß Fig. 1 aufspreizbar und gegensinnig wieder in die Ruhestellung gegen den Längsträger 2 einklappbar. Zur Aufnahme der Streben ist der Längsträger 2 mit Aufnahmenuten 8, 9 versehen. Wie sich insbesondere aus der Fig. 2 ergibt, sind die die Tragarme 4 bildenden Streben an den beiden Enden des Längsträgers 2 in Richtung ihrer Anlenkachsen 7 gegeneinander versetzt angeordnet, um sie aufgrund ihrer Länge im eingeklappten Zustand nebeneinander entlang des Längsträgers 2 lagern zu können, dessen Mindestlänge somit der Länge der Tragarme 4 entspricht. Da die Fußstreben 3 eine Länge kleiner als die halbe Länge der Tragarme 4 aufweisen, können die an den beiden Enden des Längsträgers 2 angelenkten Fußstreben 3 paarweise in eine gemeinsame Aufnahmenut 8 eingeklappt werden, wie dies der Fig. 4 entnommen werden kann.

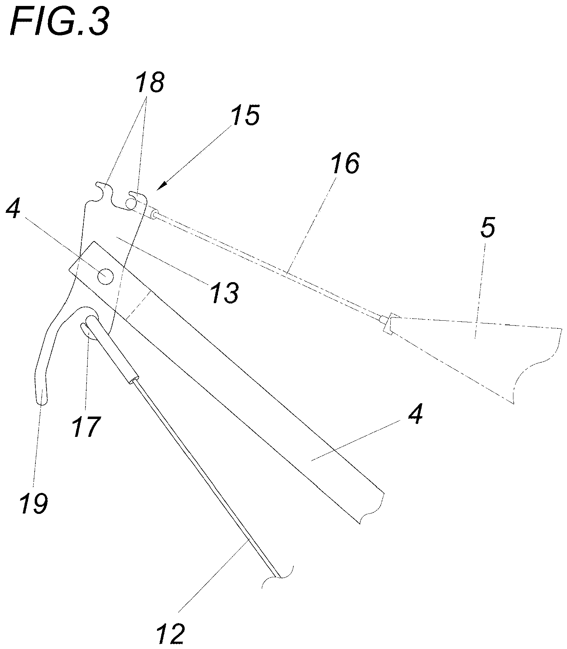

Die ausgespreizte Arbeitsstellung der Streben wird zwar durch Anschläge 10, 11 vorgegeben, doch sollen über diese Anschläge 10, 11 im Wesentlichen keine Belastungsmomente der Streben abgetragen werden. Aus diesem Grund sind die Streben an den beiden Enden des Längsträgers 2 je mit einem Zugmittel 12 verbunden, das zum Spannungsausgleich vorzugsweise in Form einer endlosen Schlaufe geführt wird, was jedoch nicht zwingend ist. Während die Zugmittel 12 um die Enden der Fußstreben 3 lediglich umgelenkt werden, greifen sie an den Tragarmen 4 nicht unmittelbar, sondern über doppelarmige Schwenkhebel 13 an, die an den Tragarmenden um zu den Anlenkachsen 7 parallele Achsen 14 frei drehbar gelagert sind. Die Schwenkhebel 13 bilden mit ihrem dem Hebelarm für das Zugmittel 14 gegenüberliegenden Hebelarm einen Anschlagpunkt 15 für die Hängematte 5, die mithilfe einer Zugmittelschlaufe 16 in eine den Anschlagpunkt 15 bildende Hakenöffnung einhängbar ist, wie dies insbesondere der Fig. 3 entnommen werden kann. Da der Schwenkhebel 13 zum Unterschied zu nur einem Einhängehaken 17 für das Aufnehmen des die drei Strebenenden verbindenden Zugmittels 12 zwei Einhängehaken 18 für die Hängematte 5 bildet, kann durch die Wahl des jeweiligen Einhängehakens 18 der jeweilige Durchhang der Hängematte 5 im unbelasteten Zustand eingestellt werden. Im belasteten Zustand ergibt sich durch die Schwenkhebel 13 ein Belastungsausgleich, der für eine weitgehend momentfreie Belastung der Streben sorgt. Um das Einhängen der Zugmittel 12 bzw. der Zugmittelschlaufe 16 in die Einhängehaken 17, 18 zu erleichtern, kann der Schwenkhebel 13 mit einem Griffansatz 19 ausgebildet werden.

Die Fußstreben 3 auf jedem Ende des Längsträgers 2 müssen jedoch nicht nur miteinander und mit dem Tragarm 4 durch die Zugmittel 12 verbunden, sondern auch gegenüber den Fußstreben 3 an den gegenüberliegenden Enden des Längsträgers 2 abgespannt werden. Zu diesem Zweck ist ein vorzugsweise ebenfalls endlos geführtes Zugmittel 20 vorgesehen, dessen Abschnitte zwischen den beiden Enden des Längsträgers 2 entweder parallel geführt sind oder gekreuzt verlaufen.

Der als hohle Kastenträger ausgebildete Längsträger 2 kann vorteilhaft als Stauraum, insbesondere für die Hängematte 5 und die Zugmittel 12, 20, genützt werden. Zu diesem Zweck kann innerhalb des Kastenträgers ein den Stauraum bildendes Rohrstück 21 vorgesehen sein, das stirnseitig durch einen öffenbaren Deckel 22 verschlossen ist. Ein als Klappe ausgebildeter Deckel 22 ist in der Fig. 4 in einer teilweisen Offenstellung strichpunktiert angedeutet.

## Patentansprüche

1. Zusammenlegbares Traggestell für eine Hängematte (5) mit einem Gestellkörper (1) aus einem Längsträger (2) und je drei an den beiden Enden des Längsträgers (2) vorgesehenen Streben, von denen zwei als Fußstreben (3) und die dritte Strebe als Tragarm (4) mit einem Anschlagpunkt (15) für die Hängematte (5) dienen, wobei jeweils die drei Streben an den beiden Enden des Längsträgers (2) als auch die Fußstreben (3) an den einander gegenüberliegenden Enden des Längsträgers (2) miteinander durch an den Strebenenden angreifende Zugmittel (12, 20) verbunden und aus einer gegen den Längsträger (2) eingeklappten Ruhestellung in eine vom Längsträger (2) abgespreizte Arbeitsstellung ausklappbar sind, **dadurch gekennzeichnet, dass** der Anschlagpunkt (15) für die Hängematte (5) an den beiden Tragarmen (4) an einem Arm eines doppelarmigen Schwenkhebels (13) vorgesehen ist, an dessen anderem Arm die Zugmittel (14) zu den beiden Fußstreben (3) angreifen.

2. Traggestell nach Anspruch 1, **dadurch gekennzeichnet, dass** der Längsträger (2) Aufnahmenuten (8, 9) für die in die Ruhestellung eingeklappten Streben aufweist.

3. Traggestell nach Anspruch 2, **dadurch gekennzeichnet, dass** die die Tragarme (4) bildenden Streben gegeneinander versetzt am Längsträger (2) angelenkt sind.

4. Traggestell nach einem der Ansprüche 1 bis 3, **dadurch gekennzeichnet, dass** die Zugmittel (12) zwischen den Tragarmen (4) und den zugehörigen Fußstreben (3) eine verschiebbar in den Schwenkhebeln (13) der Tragarme (4) einhängbare Schlaufe bilden.

5. Traggestell nach einem der Ansprüche 1 bis 4, **dadurch gekennzeichnet, dass** der Längsträger (2) einen einen Stauraum bildenden, hohlen Kastenträger umfasst.

## Claims

1. Collapsible support frame for a hammock (5), comprising a frame body (1) formed from a longitudinal member (2) and three struts provided at each of the two ends of the longitudinal member (2), two of which serve as foot struts (3) and the third strut serves as a supporting arm (4) with an attachment point (15) for the hammock (5), wherein the three struts at the two ends of the longitudinal member (2) as well as the foot struts (3) at the opposite ends of the longitudinal member (2) are connected to one another, in each case, by tension means (12, 20) engaging at the strut ends and the struts can be folded out from an idle position, in which they are folded in against the longitudinal member (2), into a working position in which they are splayed out from the longitudinal member (2), **characterized in that** the attachment point (15) for the hammock (5) on the two supporting arms (4) is provided on one arm of a double-armed pivot lever (13), with the tension means (14) for the two foot struts (3) engaging on the other arm of said pivot lever.

2. Support frame according to claim 1, **characterized in that** the longitudinal member (2) has receiving grooves (8, 9) for the struts folded into the idle position.

3. Support frame according to claim 2, **characterized in that** the struts forming the supporting arms (4) are hinged to the longitudinal member (2) in a mutually offset manner.

4. Support frame according to one of the claims 1 to 3, **characterized in that** the tension means (12) between the supporting arms (4) and the associated foot struts (3) form a loop which can be displaceably suspended in the pivot levers (13) of the supporting arms (4).

5. Support frame according to one of claims 1 to 4, **characterized in that** the longitudinal member (2) comprises a hollow box girder forming a storage space.

## Revendications

1. Structure de support pliante pour un hamac (5), comprenant un corps de structure (1) composé d'un longeron (2) et dans chaque cas de trois montants disposés aux deux extrémités du longeron (2), dont deux servent de montant formant pied (3) alors que le troisième sert de bras porteur (4) avec un point de butée (15) pour le hamac (5), dans laquelle les trois montants aux deux extrémités du longeron (2) ainsi que les montants formant pied (3) aux extrémités opposées du longeron (2) sont connectés les uns aux autres par l'intermédiaire de moyens de traction (12, 20) et peuvent être dépliés afin de passer d'une position de repos repliée contre le longeron (2) à une position de travail écartée du longeron (2), **caractérisée en ce que** le point de butée (15) pour le hamac (5) se situe sur les deux bras porteurs (4) sur un bras d'un levier de pivotement à deux bras (13), sur l'autre bras duquel les moyens de traction (14) vers les deux montants de pied (3) s'appliquent.

2. Structure de support selon la revendication 1, **caractérisée en ce que** le longeron (2) présente des rainures de réception (8, 9) destinées à recevoir les montants repliés dans la position de repos.

3. Structure de support selon la revendication 2, **caractérisée en ce que** les montants formant les bras porteurs (4) sont articulés sur le longeron (2) d'une façon décalée les uns par rapport aux autres.

4. Structure de support selon l'une quelconque des revendications 1 à 3, **caractérisée en ce que** les moyens de traction (12) forment entre les bras porteurs (4) et les montants formant pied associés (3) une boucle qui peut être accrochée de façon coulissante dans les leviers de pivotement (13) des bras porteurs (4).

5. Structure de support selon l'une quelconque des revendications 1 à 4, **caractérisée en ce que** le longeron (2) comprend une poutre caisson creuse qui forme un espace de rangement.
